Europäisches Patentamt

European Patent Office

Office européen des brevets

(11) Publication number: 0 108 273
A2

# EUROPEAN PATENT APPLICATION

(21) Application number: 83110092.0

(22) Date of filing: 20.08.79

(51) Int. Cl.³: H 01 L 29/743
H 01 L 29/60

(30) Priority: 18.08.78 JP 100726/78

(43) Date of publication of application:
16.05.84 Bulletin 84/20

(84) Designated Contracting States:
DE GB

(60) Publication number of the earlier application
in accordance with Art. 76 EPC: 0 008 535

(71) Applicant: Kabushiki Kaisha Meidensha
1-17, Ohsaki 2-chome
Shinagawa-ku Tokyo 141(JP)

(72) Inventor: Sueoka, Tetsuro
284-6, Toya
Numazu-shi Shizuoka-ken(JP)

(72) Inventor: Ishibashi, Satoshi
32-9, Higashimine-machi
Ota-ku Tokyo(JP)

(74) Representative: Bardo, Julian Eason
Abel & Imray Northumberland House 303-306 High
Holborn
London, WC1V 7LH(GB)

(54) A gate controlled semiconductor device.

(57) A gate controlled semiconductor device comprises a semiconductor element (1) of a wafer of semiconductor material having four layers $P_1$, $N_1$, $P_2$, $N_2$) of alternate conductivity types defining three series arranged junctions, a cathode electrode divided into a plurality of cathode electrode assemblies (K) including a metallic layer (11) deposited on a cathode-emitter layer (5), formed on a surface of said semiconductor element (1), an anode electrode assembly (A), at least one gate electrode assembly ($G_1$, $G_2$) for supplying an OFF signal to said semiconductor element (1), and impedance adjusting means for changing the turn-off time of the main current of said semiconductor element (1) and for equalizing the impedance of current paths between at least one drain (9, 18) of said gate assembly ($G_1$, $G_2$) and said cathode-emitter layer (5).

FIG.8

- 1 -

## A Gate Controlled Semiconductor Device

The present invention relates to a semiconductor device, and more particularly to an improved gate structure for a gate controlled semiconductor device.

A gate control semiconductor device such as, for example, a gate turn-off thyristor is constructed similarly to the more usual reverse-blocking three-terminal thyristor. The gate turn-off thyristor is switched from a non-conductive state to a conductive state by supplying a current to a gate electrode thereof, when main current flows into the gate turn-off thyristor. The gate turn-off thyristor is returned to the non-conductive state from the conductive state by supplying a negative current, which is the current flowing in the reverse direction for reverse-biasing the cathode junction. The configuration of the cathode electrode is important to the turn-off performance of the device.

When a gate turn-off thyristor is turned off by supplying a reverse-biasing signal the reduction of the main current of the gate turn-off thyristor starts in the vicinity of the gate electrode, and spreads to the central portion and finally reaches the cathode-emitter layer. Various configurations of the cathode and the gate are used or proposed in order to enhance current interrupting capability. One method makes the traverse-resistance of the base layer small. In view of the above, the gate turn-off thyristor is designed so that the cathode electrode is located as near the gate electrode as possible, in order to eliminate the inner impedance between the cathode and the gate electrode. Accordingly, the cathode electrode is divided into many small pieces and, as a result, the length of the opposing faces of the cathode electrode and the gate electrode become inevitably long and, in particular, the cathode junction of a large capacity gate turn-off thyristor is divided into a large number of small pieces.

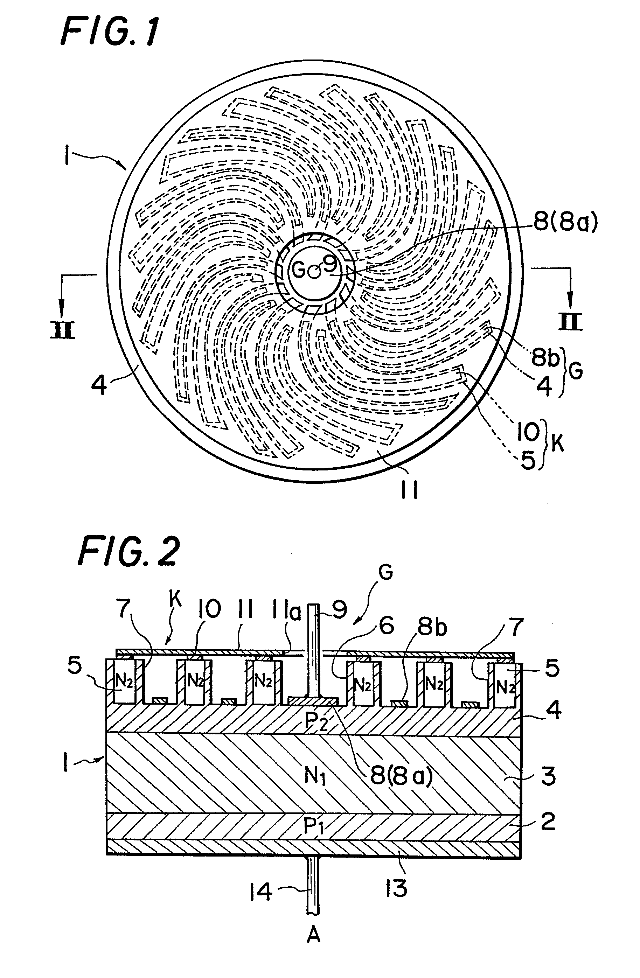

Figures 1 and 2 show an example of the conventional gate controlled semiconductor device in the form of a gate turn-off thyristor. In Figures 1 and 2, the reference numeral 1 shows a semiconductor element. The semiconductor element 1 comprises a $P_1$ layer 2 which is a P-type region, an $N_1$ layer bulk 3, $P_2$ layer 4 which is a P-type region and a plurality of $N_2$ layers which are N-type regions.

The reference numeral 6 is a cavity provided on the centre portion of a surface of the $P_2$ layer 4. A plurality of involute-shaped slots 7 are provided on the surface of the $P_2$ layer 4 so as to communicate with the cavity 6. The slots 6 are spaced apart equidistantally A metallic layer 8 is arranged in a bottom portion of the cavity 6, and the metallic layer 8 consists of a bridging segment 8a and a plurality of involute-shaped extensions 8b extending respectively along to the slot 7 from the bridging segment 8a toward the periphery of the semiconductor element 1. A lead 9 is connected to the bridging segment 8a of the metallic layer 8 to form a gate electrode assembly G. A plurality of involute-shaped metallic layers 10 are provided, respectively, on each $N_2$ layer 5. A circular-shaped metallic layer 11 having a bore 11a is secured on the metallic layers 10 to form a bridging member. K is the cathode electrode assembly. In the cathode electrode assembly K, the gap between adjacent emitter regions is the same over the entire assembly.

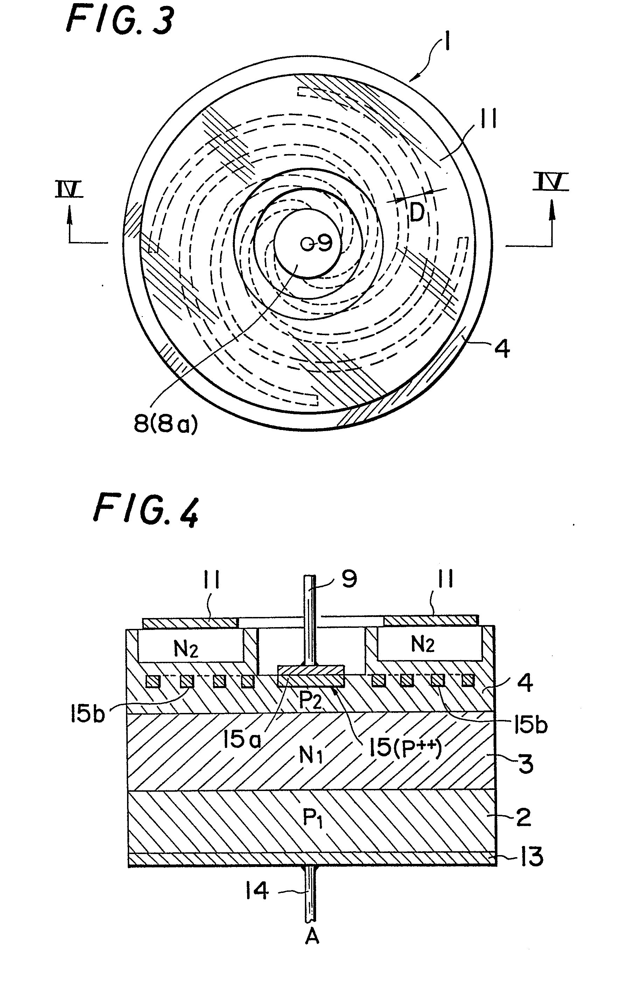

Figures 3 and 4 show another example of a gate turn-off thyristor. In the gate turn-off thyristor shown in Figures 3 and 4, a low resistance layer 15 is embedded in the $P_2$ layer 4. The low resistance layer 15 is formed by diffusing a high concentration $P^{++}$-type impurity into the $P_2$ layer 4. The low resistance layer 15 consists of a circular-shaped bridging portion 15a provided in the centre portion of the $P_2$ layer 4 and a plurality of involute-shaped extensions 15b extending radially and spirally from the bridging portion 15a toward the periphery of the conductive element 1. The distance D between adjacent extensions 15b is equal throughout, as in the case of the device of Figures 1 and 2. A metallic layer 8 is provided so as to contact the bridging portion 15a of the low resistance layer 15 to form a gate electrode assembly G. A plurality of involute-shaped $N_2$ layers 5 are provided on the $P_2$ layer 4. A ring shaped $N_2$ layer 5 is provided on the surface of the $P_2$ layer 4, and a ring shaped metallic layer 11 is secured on the $N_2$ layer 5 to form a cathode electrode assembly K. Accordingly, the device of Figures 3 and 4 is, substantially, an involute-type gate turn-off thyristor similar to that of Figures 1 and 2. In the device of Figures 3 and 4, the effective area of the element 1 is enhanced because of the $P^{++}$ layer 5 embedded in the $P_2$ layer 4. However, the strength against a reversing voltage between the gate electrode assembly G and the cathode electrode assembly K is superior to that of the device of Figures 1 and 2, because the $P^{++}$ layer 5 is provided in the $P_2$ layer 4.

In the devices shown in Figures 1 and 2 and in Figures 3 and 4, when the element 1 is conductive, a main current flows from the anode electrode assembly A to the cathode electrode assembly K by way of the $P_1 N_1 P_2 N_2$ layers. In turning OFF the semiconductor element 1, an OFF signal is supplied to the gate electrode assembly G from the external gate lead 9, and thereby the conductive element 1

- 4 -

is swept of the main current by means of the gate electrode assembly G.

When turning OFF the main current, the current flows toward the external gate electrode 9 from the cathode electrode assembly K so as to apply the reverse-bias to the junction formed by the $P_2$ layer 4 and $N_2$ layer 5. In this case, the current flows from the cathode assembly K to the gate electrode assembly G, and thereby the portion of the $N_2$ layer 5 opposite to the gate electrode assembly G is turned OFF. Thereafter, each cathode portion opposite to the gate electrode is, in turn, returned to an OFF state.

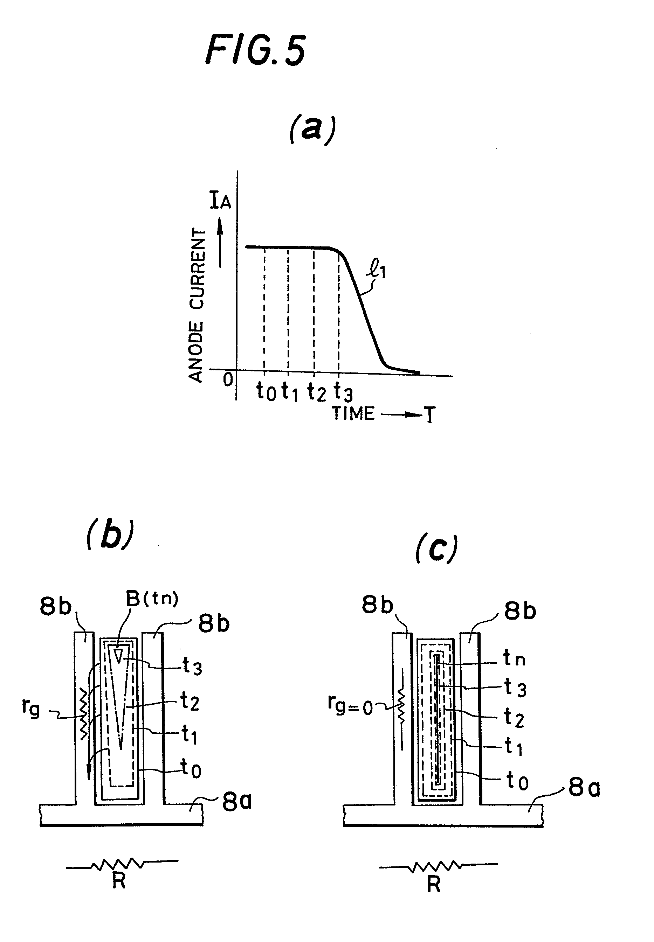

When the $N_2$ layer 3 which forms the cathode electrode assembly K is swept of main current by the OFF signal supplied from the gate electrode assembly G, the main current which flows in the cathode region may be turned OFF quickly if a resistance component does not exist in the gate electrode assembly G, as illustrated in Figures 5A to 5C. Figures 5A to 5C show the variation of conductive areas in a cathode area when the main current (anode current) $I_A$ is turned OFF. In more detail, the main current of the semiconductor element 1 is assumed to be interrupted during the time interval $T=t_o$ to $t_n$, as is shown by a curve $\ell_1$ in Figure 5A. By applying the reverse-bias signal to the cathode-emitter layer, the conductive element 1 is turned off during time interval $t_o$ to $t_n$. As is shown in Figure 5C, if the transverse resistance value R and the resistance value $r_g$ of the gate electrode assembly G are zero, respectively, the turn OFF zones of the main current at various times may be distributed as is shown by dotted lines in Figures 5A and 5C and, as a result, the main current $I_A$ which flows in the radial and centre portions between the pair of extensions 8b and 8b is finally turned off, as is shown hypothetically by dotted lines of Figures 5A and 5C.

In the actual gate turn-off thyristor, there is some transverse resistance and gate resistance, and some reverse-bias voltage is dropped due to the impedance of the gate electrode assembly G, the transverse resistance and the gate current $I_g$. The voltage drop of the reverse-bias voltage becomes higher as the distance from the terminal of the gate electrode assembly G becomes longer. The turning off regions are distributed as is shown by dotted lines of Figure 5B. The turn OFF time of the main current $I_A$ in the cathode electrode assembly K increases as the distance between the terminal of the gate electrode and any portion of cathode electrode increases. Consequently, the main current $I_A$ is finally concentrated to a point B which is localized at the radial and extreme end portion of the centre line of the cathode area.

In the devices described above, the area occupied by the main current in the cathode electrode assembly K becomes progressively smaller and, therefore, the main current $I_A$ is finally turned off when the gate impedance is highest, because the gate current $I_g$ flows through the longest current path. It is, accordingly, impossible to manufacture a large current capacity gate controlled semiconductive device, since the current interrupting capability is restricted by the length of the gate current path. It is important that the internal impedance of the gate electrode as well as the transverse resistance of the cathode layer be lowered.

Accordingly, an object of the invention is to provide a high performance gate controlled semiconductor device in which the turn-off of the main current is improved.

According to the present invention a gate controlled semiconductor device comprises a semiconductor element wafer of semiconductor material having four layers of alternate conductivity types defining three series arranged junctions, said semiconductor element comprises an anode electrode assembly, a cathode electrode assembly, a gate electrode assembly surrounding said cathode electrode assembly, and means for changing the turn-off timing of the main current of said semiconductor element.

The invention will be more described fully with reference to the drawings in which:

Figure 1   is a plan view of a prior art gate controlled semiconductor device,

Figure 2   is a vertical sectional view of the prior art gate controlled semiconductor device taken along line II-II of Figure 1,

Figure 3   is a plan view of another prior art gate controlled semiconductor device,

Figure 4   is a vertical sectional view of the prior art gate controlled semiconductor device taken along line IV-IV of Figure 3,

Figure 5A is a graph showing an anode current characteristic of a prior art gate controlled semiconductor device,

Figure 5B is an enlarged plan view showing a turn-off characteristic of a prior art gate controlled semiconductor device,

Figure 5C is an enlarged plan view showing an ideal turn-off characteristic of a gate controlled semiconductor device,

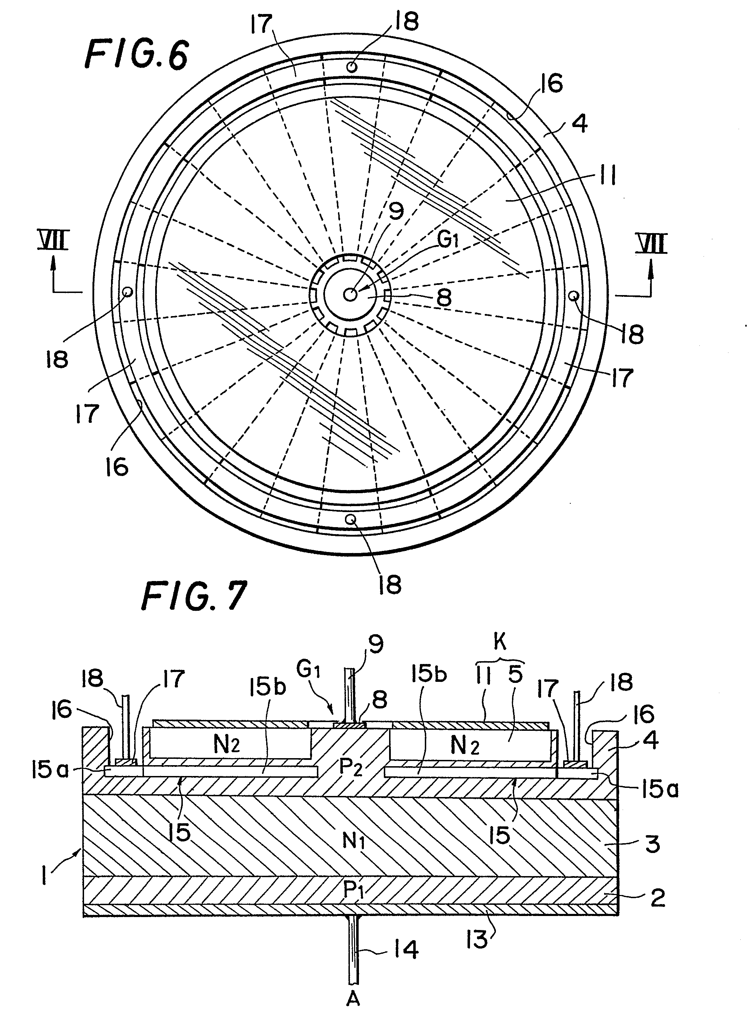

Figure 6   is a plan view of a gate controlled semiconductor device of the present invention,

Figure 7   is a vertical sectional view of the gate controlled semiconductor device of the present invention taken along line VII-VII of Figure 6,

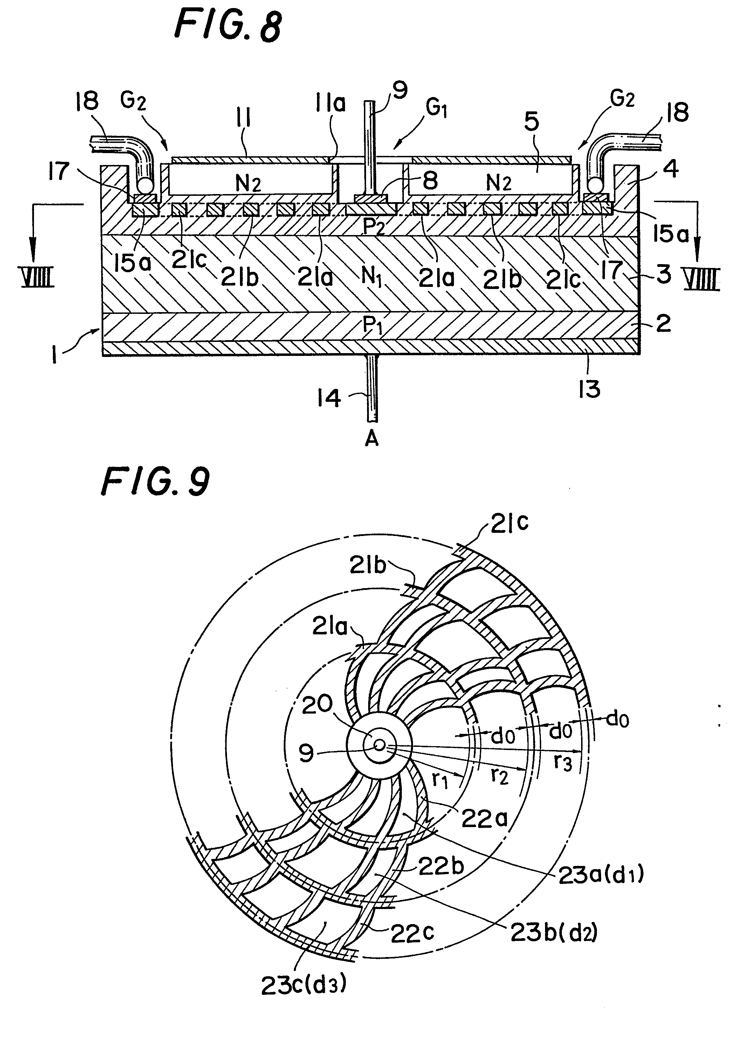

Figure 8   is a vertical sectional view of a second gate controlled semiconductor device embodying the present invention,

Figure 9   is a sectional view of the gate controlled semiconductor device of the second embodiment of the invention taken along line IX-IX of Figure 8,

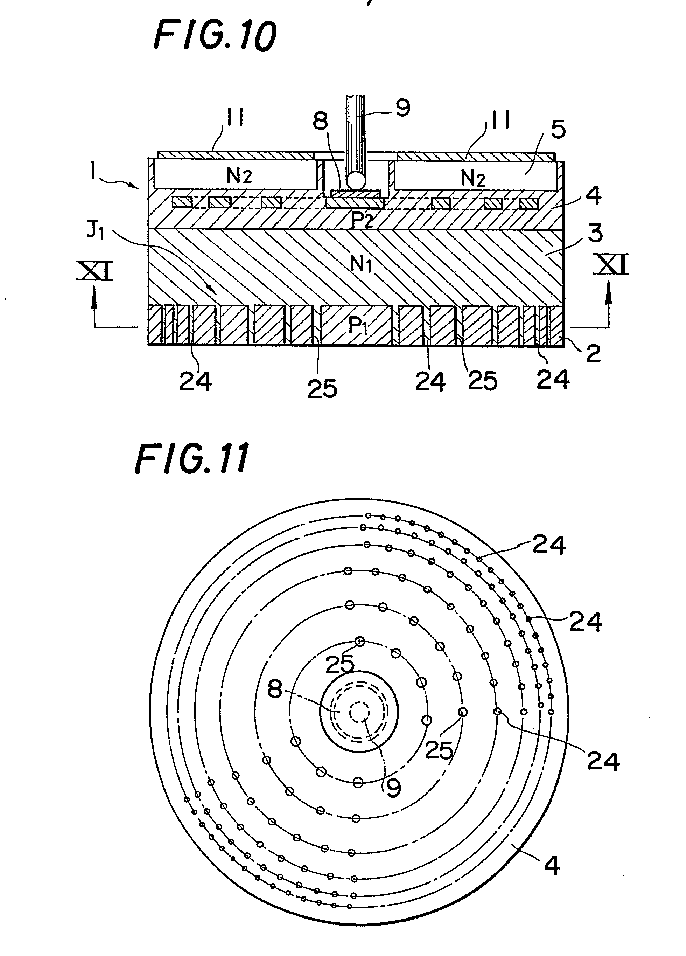

Figure 10 is a vertical sectional view of a third gate controlled semiconductor device embodying the present invention,

Figure 11 is a sectional view of the gate controlled semiconductor device of the second embodiment of the invention taken along line XI-XI of Figure 10,

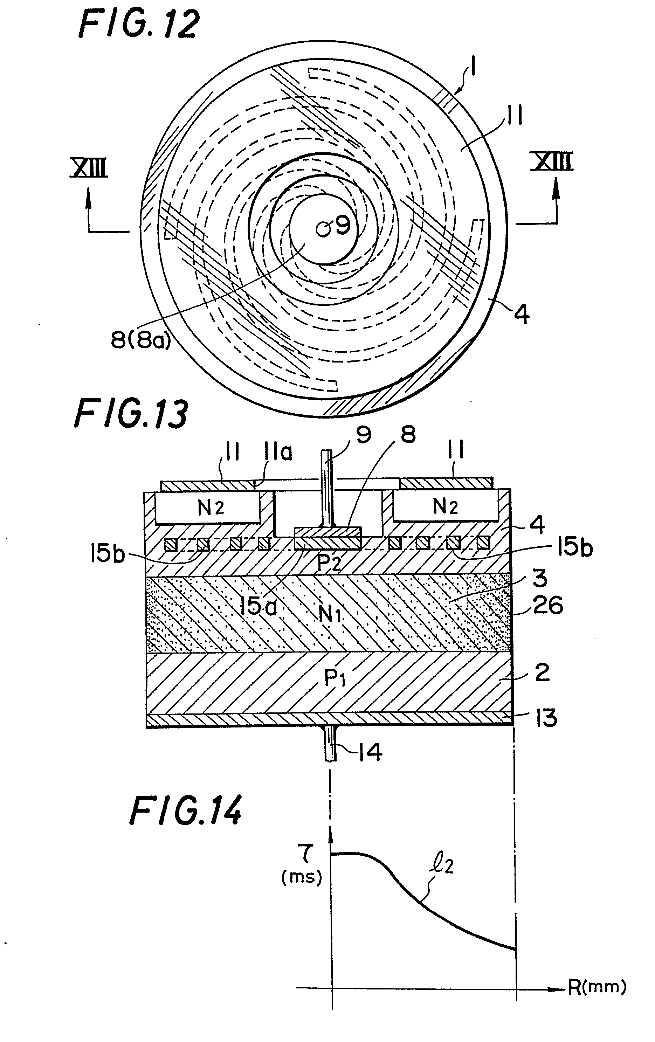

Figure 12 is a plan view of a modification of the gate controlled semiconductor device of Figures 10 and 11,

Figure 13 is a vertical sectional view of the gate controlled semiconductor device taken along line XIII-XIII of Figure 12, and

Figure 14 is a graph showing a life-time characteristic of the main current flowing in the gate controlled semiconductor device of Figures 12 and 13 during switch off.

With reference to Figures 6 and 7 of the drawings, in a gate controlled semiconductor device, a semiconductor element 1, the bulk of which is weakly N-type, includes a $P_1$ layer 2 which is a P-type diffused region, an $N_1$ bulk layer 3, a $P_2$ layer 4 which is a P-type diffused region and a ring shaped $N_2$ layer 5 which is an N-type diffused region.

A device of the kind described above is made essentially as follows.

First, a weakly N-type silicon wafer is prepared. Next $P_1$ and $P_2$ layers are grown over each of the end surfaces of the wafer by the diffusion of gallium. After that a cathode layer $N_2$ is formed by diffusing N-type layer to a given depth. Then, an aluminium layer is evaporated to form an ohmic contact. A metallic layer 8 is provided on a centre portion of the surface of the $P_2$ layer 4, and a lead 9 is connected to the metallic layer 8. A first gate

electrode assembly $G_1$ comprises the $P_2$ layer 4, the metallic layer 8 and the lead 9.

As is best shown in Figures 6 and 7, a low resistance layer 15 is embedded in the $P_2$ layer 4. The low resistance layer 15 consists of a circular-shaped bridging portion 15a localized in the outer portion of the $N_2$ layer 4 and a plurality of extending portions 15b extending radially from the bridging portion 15a, toward the centre portion of the $P_2$ layer 4. As is illustrated in Figure 6, each of the extending portions 15b of the low resistance layer 15 is sector-shaped so that the width of each extending portion 15b becomes gradually smaller at the end. Accordingly, the width $d_1$ of the end portion of the effective emitter layer 19 is smaller than the width $d_2$ of the base portion.

A circular slot 16 is provided on the surface of the $P_2$ layer 4 located at the outer side of the $P_2$ layer 4 by etching the surface of the $P_2$ layer 4 up to the upper surface of the bridging portion 15a of the low resistance layer 15. A circular-shaped metallic layer 17 is arranged in the slot 16 so as to contact the bridging portion 15d of the high density $P^{++}$ impurity layer 15. The metallic layer 17 is made by evaporating aluminium.

Terminal leads 18 are connected to the metallic layer 16. The leads 18 are relatively big aluminium wires which have low impedance. Accordingly, a second gate electrode assembly $G_2$ comprises the low resistance layer 15 consisting of the high impurity $P^{++}$ layer and consisting of the bridging portion 15a and the plurality of sector-shaped extending portions 15b.

A cathode electrode assembly K is formed by the $N_2$ layer 5 and the metallic layer 11. As is shown in Figure 6, the $N_2$ layer 5 is a main emitter layer, and a plurality of sector portions 5a of the $N_2$ layer 5 form an effective emitter layer when the conductive element 1 is activated. It is important that each of the extensions 15b is formed of a radial sector in which the width of the end portion is narrower than that of the base portion connected to the bridging portion 15a of the low resistance layer 15, and that the cathode layer is substantially divided into many pieces.

In operation, an ON signal is supplied from the first gate electrode assembly $G_1$ and, an OFF signal is supplied from the second gate electrode assembly $G_2$. During turn-off current in the element 1 is swept from the element by the second electrode assembly $G_2$. When the ON signal is supplied between the cathode electrode assembly K and the first gate electrode assembly $G_1$, the gate current flows in a circuit which is formed by the first gate electrode assembly $G_1$, the $P_2$ layer 4, the $N_1$ layer 3, the $N_2$ layer 5 (cathode layer) and the second gate electrode assembly $G_2$. The gate current causes a portion of the $N_2$ layer 5 on the side of second gate electrode assembly $G_2$ to turn on, and thereafter the main current begins to flow from the anode electrode assembly A to the cathode electrode assembly K. During flow of the main current, the conductive region of the $N_2$ layer 5 spreads throughout the region of the $N_2$ layer 5 from the second gate electrode assembly side of the $N_2$ layer 5.

When turning off of the main current occurs, gate turn off current flows toward the cathode electrode assembly K from the leads 18 of the second gate electrode assembly $G_2$ so as to apply reverse-bias to the junctions formed by the $P_2$ layer 4 and the $N_2$ layer 5 by way of a circuit formed by the circular-shaped metallic layer 17, the bridging portion 15a of the low resistance layer (the $P^{++}$ impurity layer 15), each of the extensions 15b of the $P^{++}$ impurity layer 15 and the $P_2$ layer 4, and thereby each portion opposite to the second gate electrode assembly $G_2$ is, in turn, returned to the off state.

In turn off of the device, the main current is simultaneously interrupted in the whole surface of the cathode layer, because the resistance values are made equal in all gate current paths by constructing the effective emitter layer 19 of the semiconductor element 1 so that the width of the end portion in the extending portion 15b becomes smaller than that of the base portion thereof. In the effective emitter layer 19, the width $d_1$ in the far portion from the metallic layer 17 is smaller than the nearest portion thereto. The ratio of the widths $d_1$ and $d_2$ of the effective emitter layer is determined by the resistance value in the radial direction of the low resistance layer 15 and the transverse resistance value of the P-type base layer.

In comparing gate controlled semiconductor devices shown in Figures 1 to 4 and the gate controlled semiconductor device of Figures 6 and 7, a $P_1N_1P_2$ layer was manufactured by selectively diffusing gallium to an N-type silicon bulk, and thereafter Boron was partially diffused on one surface of the NPN layer so that the sheet resistance became $0.8 \, \Omega/mm^2$. Thereafter, an N-type silicon layer was formed on the Boron diffused surface by the epitaxial method so that the bulk resistance became $15 \, \Omega\text{-m}$. The ring-shaped cathode layer was formed on the surface of the N-type silicon layer and phosphorous was selectively diffused into the silicon layer.

For the gate controlled semiconductor devices constructed above, the gate current value required was to be 0.2 to 0.5 amperes and the forward voltage drop was to be 2.5 to 3.0 volts. Further the voltage rating was to be 850 to 1400 volts. The same performance was obtained in the prior art device and the device of the present invention for the gating current characteristic, the forward voltage drop and the voltage rating. In the prior art gate controlled semiconductor device, the turning-off time interval was 3.0 $\mu$s and the rated current was 150 to 200 amperes. In the gate controlled semiconductor device of the present invention, the turn-off time interval was 1.5 $\mu$ s and the rated current was 200 to 400 amperes. As is obvious from the above data, the gate controlled semiconductor device of the present invention is superior to that of the prior art gate controlled semiconductor devices in respect of the current capacity and the turn-off characteristic.

Figures 8 and 9 illustrate a gate turn-off thyristor which also employs in the invention. In the gate turn-off thyristor shown in Figures 8 and 9, a disc-shaped low resistance layer 20 is embedded in the $P_2$ layer 4, and a plurality of ring-shaped low resistance layers 21a, 21b and 21c are provided concentrically with the low resistance layer 20. A plurality of involute-shaped low resistance layers 22a are provided in the $P_2$ layer 4. Each of the low resistance layers 20, 21a to 22c is, respectively, formed by diffusing the high impurity $P^{++}$-type material. The layers 22a extend from the layer 20 toward the ring-shaped low resistance layer 21a and are connected to the layer 21a. The low resistance layers 22a are also spaced apart equidistantly. A plurality of involute-shaped low resistance layers 22b are provided in the $P_2$ layer 4, and are connected between the ring-shaped low resistance layers 21a and 21b. A plurality of involute-shaped low resistance layers 22a are provided in the $P_2$ layer 4 and are also connected to the resistance layers 21b and 21c. A cavity 6 is provided on the surface of the $P_2$ layer 4, located to the centre portion of the $P_2$ layer 4 by etching the surface of the $P_2$ layer 4 up to the upper surface of the low resistance layer 20. A disc-shaped metallic layer 8 is provided on the low resistance layer 20 by evaporating aluminium. A first gate electrode assembly $G_1$ comprises the low resistance layer 20, the metallic layer 8 and a lead 9 connected to the metallic layer 20. A circular-shaped slot 16 is provided on the surface of the $P_2$ layer 4 located on the outer side of the $P_2$ layer 4 by etching of the surface of the $P_2$ layer 4 up to the upper surface of the outermost low resistance layer 22c. A ring-shaped metallic layer 17 is also provided on the layer 21c, and a plurality of leads 18 are connected to the metallic layer 17. A second gate electrode assembly $G_2$ comprises the low resistance layer 20 as a bridging portion, the low resistance layers 22c, the low resistance layers 22b, the metallic layer 17 and the leads 18.

In the gate controlled semiconductor device, there are effective N-type emtter layers 23a, 23b and 23c. The width $d_2$ of the effective cathode-emitter layer 23b is designed so as to be smaller than the width $d_1$ of the effective cathode-emitter layer 23a and the width $d_3$ of the effective cathode-emitter layer 23c. As is shown in Figure 8, each of the widths of the layers 21a, 21b and 21c is, respectively, $d_0$ and the radius of each of the layers 21a, 21b and 21c is, respectively, $r_1$, $r_2$ and $r_3$. Accordingly, the transverse resistance of the lower region of the effective cathode-emitter 23b is smaller than that of the lower regions of the effective cathode-emitter layers 23a and 23c.

Under these conditions, the effective cathode-emitter layer 23b is first turned OFF, and thereafter the effective cathode-emitter layers 23a and 23c are turned OFF by applying the reverse biasing signal to the cathode electrode assembly K from the first gate electrode assembly $G_1$ and the second gate electrode assembly $G_2$.

The distance between the metallic layer 17 and the region in which the main current is finally turned OFF becomes short and thereby the current interrupting capability is enhanced. Although three series connected gate electrode members are formed in the above embodiment,

- 13 -

two or more series connected gate electrode members would give the same performance.

Figures 10 and 11 show a further embodiment of the invention. The device has an involute-shaped gate electrode assembly $G_1$. A plurality of small short-circuiting holes 24 are provided in the $P_1$ layer 2, and projecting portions 25 of the $N_1$ layer 3 are situated in the holes 24 to form shorting segments. In more detail, an anode-emitter junction $J_1$ is partially short-circuited between the $P_1$-layer 2 and the $N_1$ layer 3 by the short-circuiting projections of the $N_2$ layer 3. The short-circuiting projections 25 are arranged on a plurality of circular lines so that the number of projections 25 increases in the outer side of the $P_1$ layer 2. The short-circuiting projections 25 are arranged concentrically on the $P_1$ layer 2 so that the concentrations become higher in the outer side portion of the $P_1$ layer 2 than that in the central portion.

In turning-off of the device as constructed above, the current-amplification factor is low in the outer side portion of the conductive element 1 and is high in the centre portion which is the nearest portion to the gate electrode assembly $G_1$. The turning-off operation starts at the portion furthest from the gate electrode assembly $G_1$, and the central portion of the element 1 is turned off last. Accordingly, the current interrupting capability of the device is increased since the element 1 can be turned off by driving the gate from a low impedance source.

In the device of Figures 10 and 11, many projections 25 are arranged in the periphery of the $P_2$ layer 2, and few projections 25 are provided in the central portion. The short-circuiting resistance at the periphery of the conductive element 1 is lower than that of the central portion which is the nearest portion to the gate electrode assembly $G_1$, and the impedance between the gate electrode

- 14 -

assembly $G_1$ and all regions of the semiconductor element is relatively constant. Because of the constant impedance from the gate electrode to all regions of the conductive element 1, the turn-off time interval is shortened since the main current is interrupted simultaneously in all regions of the semiconductor element 1.

With the devices as constructed above, the turn-off time interval is shortened by 50 to 70% in comparison with prior art gate controlled semiconductor devices. In addition, the current interrupting capability of the device as constructed above is much better.

Another gate controlled semiconductor device may be considered as a modification of the gate turn-off thyristor of Figures 10 and 11. One modification is to make the width of the $N_2$ layer 3 small in comparison with the distance from the gate electrode assembly $G_1$. Another modification of the device of Figures 10 and 11 is to make the width of the $P_1$ layer 2 narrow in comparison with the distance from the first gate electrode assembly $G_1$.

Figures 12 and 13 show a modification of the gate controlled semiconductor device of Figures 10 and 11. In the device of Figures 12 and 13 which also employ the present invention, a gate electrode assembly $G_1$ is provided on the centre portion of the surface of the $N_2$ layer 5 and is constructed as the involute shape similar to the device in Figures 3 and 4. In the device of Figures 12 and 13, gold is partially diffused in the $N_1$ layer 3 so that the concentration of the diffused gold 26 varies in accordance with the distance from the OFF gate electrode assembly $G_1$ in order to change the life-time of the carriers in the base layer ($N_2$ layer 3).

In more detail, the gold diffusion layer 26 is provided in the $N_3$ layer 3 so that the concentration of the gold increases with the distance from the centre portion of the $N_2$ layer 3. As one method for changing the life-time of the carriers, control of the radiation dose may also be employed.

In accordance with the device as constructed above, carrier life-time in the $N_1$ layer 3 varies as is shown in Figure 14. Namely, carrier life-time in the centre portion of the $N_2$ layer 3 is longer than in the outer side portion thereof in accordance with the distance from the gate electrode assembly $G_1$. When turning off the main current, the turn-off operation is initiated at the outer portion in which the density of the diffused gold is high and far from the gate electrode, and thereafter the main current is finally interrupted at the centre portion in which the density of the diffused gold is low and in the vicinity of the gate electrode assembly $G_1$.

The present invention is not limited to the above described embodiments and the invention is also applicable to other various semiconductor devices such as, for example, a thyristor having an amplifying function, and the like.

As is explained with reference to the above various embodiments, in the gate controlled semiconductor device in accordance with the present invention, means for making small the internal impedance between a drain terminal of the gate electrode assembly and the portion where the main current is finally interrupted is substantially provided in the semiconductor device.

Accordingly, it should be apparent that following advantages are obtained: (1) the current interrupting capability is significantly improved in comparison with the prior art device; (2) a good characteristic and economical gate turn-off thyristor can be obtained by making the internal impedance of the gate current path small; (3) since fabrication is simplified in comparison with a conventional gate controlled semiconductor device, a high-quality device is obtained without decreasing a yield; and (4) since reduction of the junction area is avoided, a high performance device is obtained without decreasing its current capacity.

Accordingly, it is to be understood that the embodiments described in detail are only illustrative of the general principles involved; other embodiments may be devised consistent with the scope of the invention.

.CLaims

1.      A     gate-controlled    semiconductor    device
comprising an element (1) of semiconductor material having
four regions (2, 3, 4, 5) of alternating conductivity types
defining three series-arranged junctions including, in
seriatim,   a    first    region    (2)    containing   first-
conductivity-type dopant, a second region (3) containing
second-conductivity-type   dopant,   a   third   region   (4)
containing first-conductivity-type dopant and a fourth
region (5) containing second-conductivity-type dopant, an
anode electrode (13) in the exposed surface of said first
region, a gate electrode assembly (8, 20, 17, 21a to 21c,
22a to 22c - Figs. 6, 7) radially extending into said
element (1) and having lower resistivity than the third
region (4), said lower-resistivity layer having an exposed
surface on which lies a metallic layer (8, 17 - Figs. 6, 7)
to which a gate terminal (9, 18 - Figs. 6, 7) is connected,
said lower-resistivity layer (20, 21a to 21c, 22a to 22c
- Figs. 6, 7) including gaps dividing a cathode electrode
assembly (5, 11) into a plurality of effective cathodes,
characterized in that the lower-resistivity layer (20, 21a
to 21c, 22a to 22c - Figs. 6, 7) comprises a bridging
portion (21a to 21c - Figs. 6, 7) provided in an outer
region of the third region (4) and a plurality of extending
portions (22a to 22c - Figs.  6, 7) which extend toward a
center region of the device, and that the device comprises
a gate electrode assembly ($G_1$, $G_2$ - Fig. 7) including a

disc-shaped low-resistance layer (20 - Figs. 6, 7) provided on the center region of the third region (4), a plurality of concentric, circular, low-resistance layers (21a to 21c - Figs. 6, 7) and a plurality of radially extending low-resistance layers (22a to 22c - Figs. 6, 7), and a plurality of effective cathodes (23a to 23c - Fig. 7) surrounded by the disc-shaped low-resistance layer (20 - Figs. 6, 7), the concentric, circular, low-resistance layers (21a to 21c - Figs. 6, 7) and the plurality of radially extending low-resistance layers (22a to 22c - Figs. 6, 7), the circumferential widths of the effective cathodes positioned far from the gate terminals (9, 18 - Figs. 6, 7) being narrower than the widths of the effective cathodes positioned near the gate terminals.

2. A gate-controlled semiconductor device as claimed in claim 1 further characterized in that said low-resistance layers (20, 21a to 21c, 22a to 22c - Figs. 6, 7) include involute-shaped portions (22a to 22c - Figs. 6, 7).

3. A gate-controlled semiconductor device as claimed in claim 1 or 2 further characterized in that said low-resistance layers (20, 21a to 21c, 22a to 22c - Figs. 6, 7) include a plurality of ring portions (21a to 21c - Figs. 6, 7).

4. A gate-controlled semiconductor device as

0108273

claimed in claim 2 or 3 further characterized in that another gate terminal (9) and a metallic layer (20 - Figs. 6, 7) connected thereto are provided at a central portion of the element (1) and the gate terminal (18) and metallic layer (17) connected thereto are provided around a peripheral portion of the element (1), and the involute-shaped portions (22a to 22c - Figs. 6, 7) are spaced further apart circumferentially near the central and peripheral portions than at radially intermediate portions.

1/7

## FIG.1

## FIG.2

## FIG. 3

## FIG. 4

# FIG.5

## (a)

## (b)

## (c)

FIG.6

FIG.7

*FIG.8*

*FIG.9*

## FIG.10

## FIG.11

## FIG.12

## FIG.13

## FIG.14